(19) Europäisches Patentamt
European Patent Office
Office européen des brevets

(11) Publication number: **0 108 650**
**A2**

(12) # EUROPEAN PATENT APPLICATION

(21) Application number: 83306844.8

(22) Date of filing: 09.11.83

(51) Int. Cl.³: H 01 L 29/60
G 11 C 17/00

(30) Priority: 09.11.82 US 440405

(43) Date of publication of application: 16.05.84 Bulletin 84/20

(84) Designated Contracting States: BE DE FR GB IT LU NL

(71) Applicant: ZYTREX CORPORATION
224 North Wolfe Road
Sunnyvale California 94086(US)

(72) Inventor: Wanlass, Frank M.
21498 Meteor Drive
Cupertino State of California 95014(US)

(74) Representative: Horton, Andrew Robert Grant et al,
BOULT, WADE & TENNANT 27 Furnival Street
London, EC4A 1PQ(GB)

(54) **Programmable MOS transistor.**

(57) Each transistor of an array is selectively programmable with a laser beam which is precisely directed to the transistor. The laser beam and the biasing voltage on a control electrode common to all transistors causes charge to be selectively placed in a trapped-charge region. In one embodiment of the invention, the laser beam is incident on a floating gate and the control electrode to provide photoelectrons which, depending on the bias potential on the control electrode, produce a net negative or positive charge in the floating gate. In another embodiment, the laser beam is incident on the control electrode to heat underlying insulator material and provide a conductive path for charge between the trapped-charge region and the appropriately biased control electrode.

30 LASER BEAM
10
26
2
2
24
20
18
12
14
22
16

FIG. 1

EP 0 108 650 A2

Croydon Printing Company Ltd.

## PROGRAMMABLE MOS TRANSISTOR

This invention relates to programmed transistors and, more particularly, to apparatus and methods for selectively programming individual ones of an array of integrated circuit transistors.

Irreversible, one-time programming of transistor arrays is accomplished in a number of ways. For example, metal-oxide-silicon (MOS) read-only memories (ROMs) have been factory programmed by selectively masking the gate thicknesses by photolithographic means. Obviously, erasure, or reprogramming, cannot be done, and if a memory cell is defective the entire circuit may have to be scrapped.

Electrical programming of an electrically isolated gate, i.e., a floating gate, of a transistor within an array making up an erasable programmable read-only memory (E-PROM) is done by transporting charge from a source or drain to the floating gate using avalanche injection. The floating gate traps the charge and creates a permanent conduction channel between the source and drain. The floating gate is surrounded by a high quality dielectric (electrical insulating) material, such as silicon dioxide, and the charge is trapped for years. To reprogram a cell in such a memory array from a one to zero state, the charge on the isolated floating gate must be removed. One method is to flood the full array of transistors with ultraviolet or x-ray light which produces photoelectrons to neutralize the stored charge on the gates. The technique of using floating gates in such an array to be programmed with avalanche injection and erased by ultraviolet radiation, is described in an article by Murray H. Woods entitled "An E-PROM's Integrity Starts With Its Cell Structure", Electronics, August 14, 1980, pages 132-136. This technique requires a programming, that is an avalanche, voltage of 25 volts. Erasure is non-selective and bulk, that is, the whole memory array is erased by flooding the array with ultraviolet radiation.

Erasure of memory contents using electrical techniques described in an article by W. S. Johnson, et al, entitled "16-K EE-PROM Relies on Tunneling for Byte-Erasable Program Storage", Electronics, February 28, 1980, pages 113-117 for an electrically-erasable programmed read-only-memory (EE-PROM) having polysilicon floating gates for the array of transistors. Another reprogrammable memory is the electrically alterable read-only memory, or EAROM, which stores charge at the interface of a silicon dioxide layer and a silicon nitride layer, described in an article by B. Cayton, entitled "Designing With Nitride-Type EAROMS", Electronics, September 15, 1977, pages 107-113. Both of these techniques require fabrication of a very thin oxide layer through which electrons tunnel, and use of a twenty (20) volt programming voltage.

The output of lasers (laser beams) also has been used, or proposed to be used, to program integrated circuitry. For example, programming with electrically fusible links, or metallization patterns, has been done by evaporating the fusible links with a laser beam. Connections cut in this manner cannot be reconnected and may be unreliable. The use of laser beams also has been proposed to provide connections between internal elements of custom circuits, such as programmable logic arrays (PLA's). A laser system using a precisely positioned laser beam to burn through a thin layer of quartz and weld together two layers of metal, is described in an article by W. Wu entitled "Automated Welding Customizes Programmable Logic Arrays", Electronics, July 14, 1982, pages 159--162. This technique is not reversible and cannot be changed if it is found that a particular element of the array is defective.

Defects in the elements, individual cells, or of large scale integrated circuits is a particularly troublesome problem, causing yields to be very low. Using redundancy techniques, spare cells can be substituted for defective cells and yields are substantially increased. The techniques described above for programming individual cells of a memory array can be used to control switches for connection of spare cells into an array. An article by J. Posa entitled "What To Do When The Bits Go Out", Electronics, July 28, 1981, pages 117-120, describes polysilicon fuses which are blown by a precisely positioned laser beam pulse. Redundancy schemes are also discussed in articles by: R. Sud, et al, "Designing Static RAMs For Yield As Well As Speed", Electronics, July 28, 1981, pages 121-126; by R. Abbott et al, "Equipping a Line of Memories With Spare Cells", Electronics, July 28, 1981, pages 127-130; and by R. Smith, "Using a Laser Beam to Substitute Good Cells For Bad", Electronics, July 28, 1981, pages 131-133.

For very large scale integration (VLSI) and wafer-scale integration (WSI), various techniques, called discretionary wiring techniques, have been proposed to implement redundancy. Some of these techniques are described in the article entitled "Whatever happened to Wafer-Scale Integration?", IEEE Spectrum, June 1982, page 18.

The present invention is a method of discretionarily programming an individual integrated circuit transistor cell in an array or arrangement of such cells, and a transistor structure especially adapted for such programming. As a major feature of the instant invention, each of the transistors is separately reprogrammable. Erasure or reprogramming of a discrete cell is accomplished without having to bulk erase the entire array or arrangement and then reprogram individual cells. Moreover, the method is non-destructive. That is, there is no melting or cutting of links involved. The connections provided by the invention can be opened or closed any number of times. And no large avalanche voltages or complicated voltage distribution networks are used. A low-voltage control potential common to all cells is provided.

The method includes, as is usual, providing a semiconductive substrate having a source region and a drain region, and providing a trapped-charged region for controlling conduction in the substrate between the source and drain regions. A control electrode is positioned adjacent the trapped-charged region with an insulator sandwiched therebetween. The control electrode is biased with a selected voltage potential and, in accordance with the invention, energy is applied selectively to each individual transistor to provide charge with the aid of the control electrode to the trapped-charge region for the control of the conduction characteristics of the transistor.

The energy most simply is applied to the individual transistors of an array by precisely directing a beam of electromagnetic radiation, preferably a laser output beam, onto the same. As will become clearer hereinafter, the laser beam alternatively can be used to simultaneously irradiate the trapped-charge region and the control electrode to produce photoelectrons to provide said charge transfer, or can be used to apply thermal energy to a portion of the insulator to temporarily increase its conductivity and thereby provide a temporary path for the conduction of charge between the control electrode and the trapped-charge region. And the trapped-charge region itself can be either an electrically conductive floating gate embedded within an insulator, or can be an interface between two dielectric (insulating) materials having differing conductive properties.

The accompanying drawings, which are incorporated in and form a part of the specification, illustrate the invention and, together with the description, serve to explain the principles of the invention and preferred embodiments thereof. In the drawings:

Fig. 1 is a diagrammatic sectional view of one preferred embodiment of an MOS transistor programmed by a laser beam which is precisely directed to an individual transistor to produce photoelectrons to charge a floating gate;

Fig. 2 is an enlarged, detail view of that portion of Fig. 1 encircled by the lines 2-2 showing emission of photoelectrons from the floating gate and from a control electrode;

Fig. 3 is a plan view of the transistor structure shown in Fig. 1;

Fig. 4 is a diagrammatic sectional elevational view of another embodiment of an MOS transistor programmed by photoelectrons stimulated by radiation emitted from a laser, wherein the control electrode is embedded in the silicon substrate;

Fig. 5 is a plan view of the transistor structure shown in Fig. 4;

Fig. 6 is a diagrammatic sectional elevational view of an embodiment of an MOS transistor structure programmed by a focused laser beam which heats an insulating layer to provide a conduction path from a control electrode to a floating gate;

Fig. 7 is a plan view of the transistor structure showing in Fig. 6;

Fig. 8 is a diagrammatic sectional elevational view of another MOS transistor programmed by a laser changing the conduction of a silicon nitride insulating layer sandwiched between a control electrode and a silicon dioxide insulating layer; and

Fig. 9 is a plan view of the transistor structure of Fig. 8.

Reference is now made in detail to the drawings which illustrate the best modes presently contemplated by the inventor of practicing the method and apparatus of the invention.

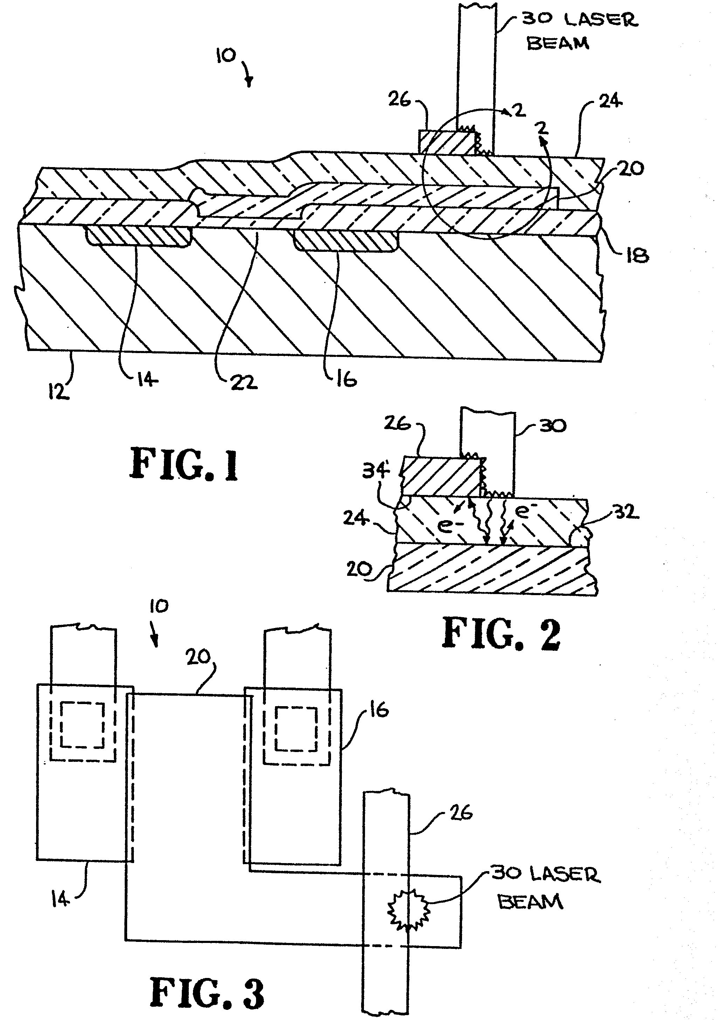

Referring to Figs. 1, 2 and 3, a programming MOS field effect transistor (FET) 10 according to the invention is shown. A silicon semi-conductive substrate 12 has diffused therein a suitably doped source region 14 and a drain region 16. Overlying the substrate 12 is a thin insulating layer 18 of silicon dioxide. Formed over a portion of the insulating layer 18 is a conductive, polysilicon floating gate 20. The floating gate 20 serves as a trapped-charge region which has charge stored therein for controlling the conduction of a field-effect channel 22 located between the source and drain regions 14, 16 adjacent the interface between the substrate 12 and the thin silicon dioxide insulating layer 18. For an N-channel device, a sufficiently large positive charge on the floating gate 20 will turn the MOS FET 10 on, that is, increase its conductivity, by drawing negative charge to the channel 22. If the transistor 10 is considered as a switch, a positive charge closes the switch or, in other words, turns it "on". Conversely, no charge or a negative charge on the floating gate 20 opens the switch or turns the transistor 10 off.

To turn on a P-channel device, a net negative charge on the floating gate 20 is provided by adding electrons to the floating gate 20. To turn off a P-channel device, a net positive charge on the floating gate 20 is obtained by removal of electrons from the floating gate 20. Note that for either a P-channel device or an N-channel device, if the floating gate 20 is surrounded with a good insulator, such as a high quality silicon dioxide of the type used in silicon gate semiconductor processes, the charge on the floating gate will remain for decades. Therefore, for all practical purposes, a MOS FET switch provided as described is considered to be permanently opened or closed depending on the charge held on its floating gate.

Such a floating gate switch arrangement is found to be useful for both programmable logic and read-only memory arrays which use a large number of general purpose circuits formed on one substrate. The individual circuits of the array are programmed to meet specific bit patterns or circuit interconnection arrangements.

Many applications of the invention are possible, e.g., to test for defective elements and program or reprogram as required. For example, with the invention, a large random-access memory (RAM) chip 700 to 800 mils square, which can store 256 K bytes and which replaces computer memory boards and small floppy-disk storage units, can be built. Another example is using a transistor structure constructed according to the invention for very large, custom PLAs having several million cross-connection points and arbitrary organization. Moreover, very large multi million bit ROM's can be constructed, having some masked coding and extra custom-coded bits or memory locations available for swapping with defective bits. Another application area is the discretionary "wiring", or connection, of portions of large scale integrated (LSI) circuits into a very large scale integrated VLSI circuits or wafer size memories of 2 to 4 megabytes. Discretionarily wired, or programmed, wafers of this type are competitive with hard magnetic disk or large memories using a number of smaller semiconductor memories.

The present invention provides a means for causing appropriate charge to be selectively placed in the floating gate 20, that is the trapped-charge region, of the transistor. An insulation radiation-transparent layer 24 of silicon dioxide is deposited over the polysilicon floating gate 20. A thin aluminum control electrode 26 is formed in a metallization process step over a portion of the insulating layer 24. The silicon, silicon dioxide, and aluminum are preferred because they are conveniently processed with MOS technology. The insulating layer 24 serves as a means for electrically insulating the trapped-charge region represented by the floating gate 24, from the control electrode 26. The control electrode is adapted to having a suitable control voltage applied thereto. It will be seen that the control electrode with the control voltage provides a means for controlling the amount of charge placed in the trapped-charge region of the floating gate 20 and, as described hereinabove, thereby determines the conduction characteristic of the MOS transistor switch.

Referring to Fig. 3, a laser beam, diagrammatically indicated by reference numeral 30, is precisely directed and aimed to irradiate the edge of the control electrode 26 and a small portion on the adjacent silicon dioxide insulating layer 24. The laser beam 30 provides an intense ultraviolet wavelength pulse which passes through the relatively thin silicon dioxide layer 24 to apply energy selectively to one transistor, which may be part of a large array of similar transistors. Contrast this to the prior art where the whole array of transistors is non-selectively flooded with ultraviolet light to erase all the transistors. Some of the laser energy is incident upon the surface 32 of the polysilicon floating gate 20 and causes photoelectrons to be emitted therefrom as shown in Fig. 3.

Ultraviolet light is selected because its photons have enough energy to overcome the work function of the material on which the laser beam impinges and to cause photoelectrons to be emitted. The polysilicon has 65 percent reflectivity for light at 2500 angstroms. Thus, some of the incident laser energy is reflected from the surface 32 of the floating gate 24 to the undersurface 34 of the aluminum control electrode 26. The ultraviolet energy striking the undersurface 34 of the control electrode 26 also causes photoelectrons to be emitted. In conjunction with proper electrical biasing of the control electrode 26, the focused laser beam 30 causes charge to be selectively placed on the floating gate 20 which serves as a trapped-charge region with a net negative or positive charge, depending on the bias voltage present on the control electrode. If the control electrode 26 is positive relative to the floating gate 20, the photoelectrons will move away from the floating gate 20 and toward the control electrode 26. This leaves the floating gate positive. If the control electrode 26 is negative relative to the floating gate 20, the photoelectrons will move toward the floating gate and away from the control electrode. This leaves the floating gate negative.

As previously discussed, for an N-channel device, a positive potential on the floating gate, typically 5 volts, increases conduction and turns the transistor switch on. On the other hand, a negative potential on the floating gate, typically 5 volts, cuts off conduction and turns the transistor switch off.

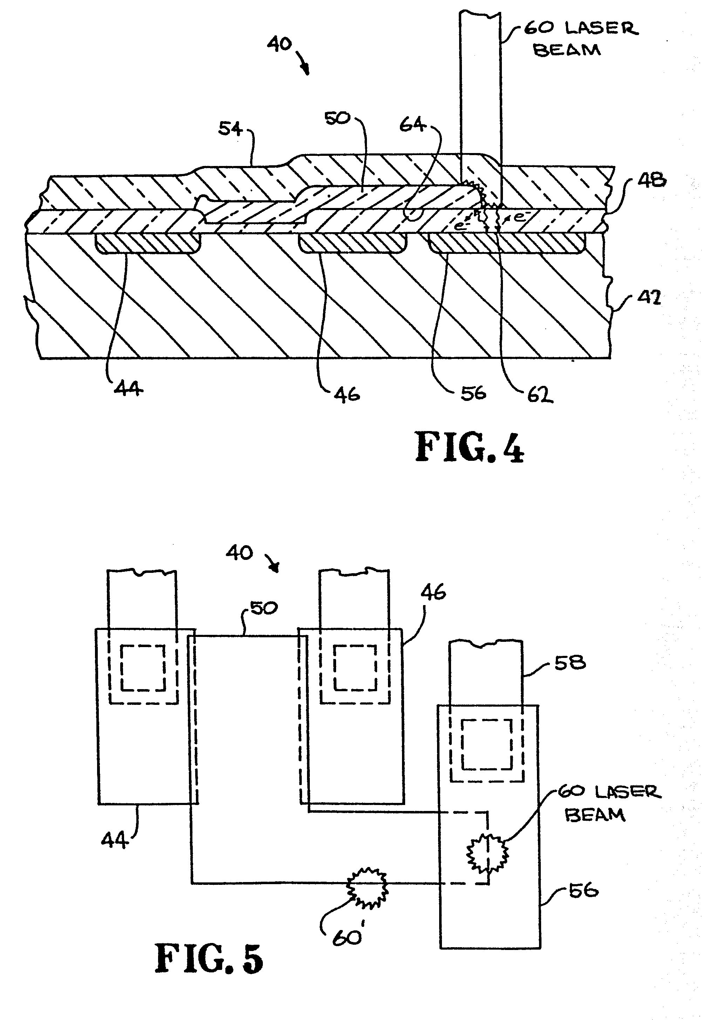

Figs. 4 and 5 diagrammatically show another embodiment of a programmable MOS transistor structure which uses a focused laser beam to irradiate that structure and produce photoelectrons. Biasing causes charge to be selectively placed in a trapped-charge region to control the conduction characteristic of the transistor. In this embodiment, an MOS transistor 40 has a silicon substrate 42 in which are diffused a source region 44 and drain region 46. The substrate 42 is overlaid with a thin silicon dioxide insulating layer 48. A polysilicon floating gate 50 is placed over the insulating layer 48. Another silicon dioxide layer 54 overlies the floating gate 50. A control electrode 56 is provided as a polysilicon buried junction connected to an aluminum metallization pattern 58 for the control voltage. In this embodiment, an intense ultraviolet laser beam 60 having a precisely-defined beam cross-sectional area is aimed to simultaneously irradiate the edge of the floating gate 50 and a portion of the buried control electrode 56 beneath the edge of the floating gate 50. The pulsed laser beam 60 passes through the silicon dioxide layers 48, 54 which are transparent to ultraviolet wavelengths.

As discussed in connection with the previously described embodiment of the invention shown in Fig. 3, some of the laser energy incident upon the surface 62 of the control electrode 56 causes photoelectrons to be emitted therefrom as shown in Fig. 4. Some of the incident laser energy is reflected from the surface 62 of the control electrode 56 to the undersurface 64 of the floating gate 50, where photoelectrons are also emitted. In conjunction with suitable biasing of the control electrode 56, the laser beam 60 causes charge to be selectively placed on the floating gate 50, in a manner as previously discussed regarding the embodiment of the invention shown in Figs. 1, 2 and 3.

If it is desired to discharge the floating gate 50 to the potential of the substrate 42, then a laser pulse 60, as indicated in Fig. 5 is focused and aimed to intercept a volume that covers both the floating gate 50 and the substrate 42.

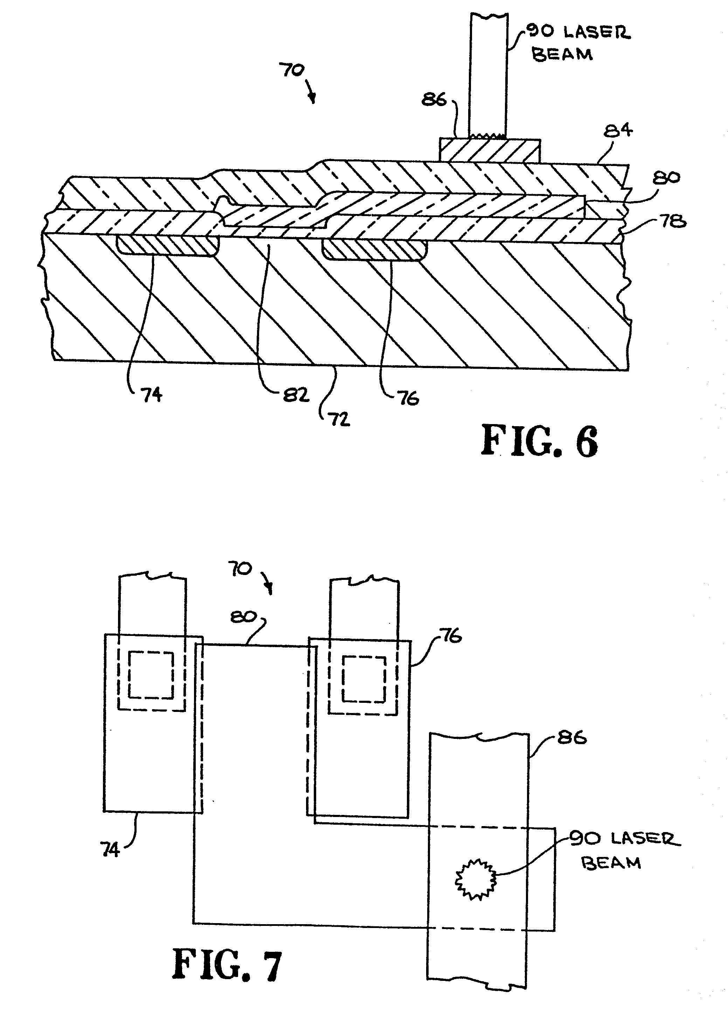

Referring now to Figs. 6 and 7, another preferred embodiment of a programmable MOS transistor switch structure 70 is shown. A silicon substrate 72 which has a source region 74 and a drain region 76 diffused therein, is overlaid with a silicon dioxide insulating layer 78. A polysilicon floating gate 80 is placed over a field-effect channel region 82 between the source and drain regions 74, 76. Another normally insulating silicon dioxide layer 84 overlies the floating gate. An aluminum control electrode 86 is metallized on the normally insulating layer 84.

A pulse from a laser beam 90, for example a beam of infrared, visible or ultraviolet radiation (hereinafter referred to collectively as "optical" radiation) with a 2 micrometer diameter having the necessary thermal energy, is precisely directed to be incident upon a small area on the top surface of the control electrode 86, as shown. The laser energy has a precisely-defined beam cross-section and locally heats the control electrode 86 which then heats that portion of the silicon dioxide insulating layer 84 below the area of laser incidence. The aluminum control electrode 86 and the silicon dioxide insulation in that affected area are each momentarily heated to a high temperature, yet below the melting points of such members, so that the conductivity of the normally nonconductive silicon dioxide insulating means 84 increases. This provides a temporary conductive path for charge between the control electrode means 86 and the trapped-charge region provided by the polysilicon floating gate 80. With a proper voltage potential on the control electrode 86, the floating gate 80 has a predetermined charge thereupon when the affected area of the insulating layer 84 cools and removes the temporary conductive path.

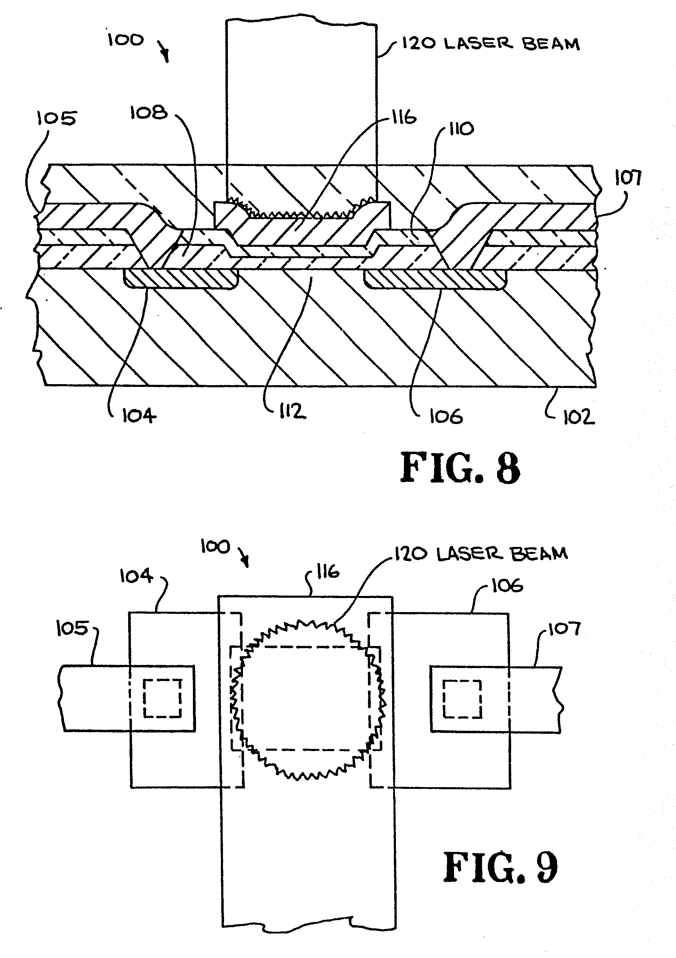

Referring to Figs. 8 and 9, a preferred alternative embodiment of a programmable MOS transistor 100 is shown. This embodiment uses materials and technology typical of silicon nitride/silicon dioxide process technology. Silicon nitride has higher conductivity than silicon dioxide at room temperature, and requires less heat energy to increase its conductivity. Other materials, such as mixtures of silicon dioxide and silicon nitride, or silicon dioxide suitably doped to provide high conductivity, are also useful. Commonly produced negative channel (NMOS), transistors have positive threshold voltages of approximately 1 volt, the gate voltage requirement to initiate conduction between source and drain regions. A gate voltage less than the threshold voltage results in an essentially open switch. The greater the gate voltage is above the threshold value, the lower is the conduction channel impedance. NMOS transistors used in current large-scale-integration designs for logic circuits typically have gate voltages of 0 and positive 5 volts applied to their gates to provide sufficient useful functioning for their logic elements. Similarly, positive channel, PMOS, transistors have threshold voltages of negative 1 volts. A negative 5 volt gate voltage turns a PMOS transistor on while a gate voltage more positive than -1 volt turns a PMOS transistor off.

The gate threshold voltage of an MOS transistor can be shifted by trapping either negative or positive charge in the gate dielectric material. For example, a gate can be constructed as a sandwich of silicon dioxide and silicon nitride layers with charge being trapped at the interface between the layers.

A preferred embodiment of a programmable MOS transistor 100 according to the invention using silicon nitride is shown in Figs. 8 and 9. A silicon substrate 102 has diffused therein a source region 104 and a drain region 106. Suitable connection is made to the source region 104 with a source-connection metallization layer 105. Similarly, connection is made to the drain region with a drain-connection metallization layer 107. In this embodiment the trapped-charge region is formed at the interface between a first layer 108 of silicon dioxide dielectric material, which is formed over the substrate 102 between the source and drain regions 104, 106, and a second layer 110 of silicon nitride dielectric material. The second layer 110 is formed over the first layer 108. An aluminum control electrode 116 is deposited over the second silicon nitride layer of the dielectric sandwich.

A pulse from a laser beam 120 having an approximate 5 micrometer diameter is precisely aimed at the surface of the control electrode 116. The laser beam pulse provides heat energy to the control electrode which, in turn, heats the underlying area of the dielectric 110. The temperature rise can be controlled by suitably selecting the laser power. The electrical conductivity of the second silicon nitride layer 110 increases much faster than does the conductivity of the first silicon dioxide layer 108, because the first silicon dioxide layer is not as good a conductor and because it is in close contact with the silicon substrate 102 which serves as a heat sink. The heated silicon nitride layer 110 is a much better electrical conductor than the silicon dioxide layer 108 so that charge passes from the control electrode 116 through the silicon nitride layer 110 to the trapped-charge region, which is located at the interface between the two layers 108, 110. After cooling, the charge remains trapped.

A plurality of trapped-charge regions, such as described in the above-preferred embodiments of the invention, can be arranged on a common substrate such that each is independently programmable by a focused laser beam. For efficient space utilization, the control electrodes for each can be connected in common to provide a common control voltage to each of the plurality of trapped-charge regions.

The foregoing description of preferred embodiments of the invention has been presented for purposes of illustration and description. They are not intended to be exhaustive or to limit the invention to the precise forms disclosed, and obviously many modifications and variations are possible in light of the above teachings. The embodiments were chosen and described in order to best explain the principles of the invention and its practical application as presently known to the inventor to thereby enable others skilled in the art to best utilize the invention in various embodiments and with various modifications as are suited to the particular use contemplated. It is intended that the scope of the invention be defined by the language of the claims appended hereto and their equivalents.

CLAIMS:

1. A method of discretionarily programming an integrated circuit transistor, comprising the steps of:

providing a semi-conductive substrate having a source region and a drain region;

providing a trapped-charge region adapted to have charge stored therein for controlling conduction in the substrate between said source and drain regions;

providing control electrode means adjacent said trapped-charge region;

providing insulating means between said trapped-charge region and said control electrode means;

biasing said control electrode means with a selected voltage potential; and

applying energy selectively to said transistor which will interact with said control electrode to cause charge to be selectively placed in said trapped-charge region for the control of the conduction characteristics of said transistor.

2. The method of Claim 1 wherein said step of selectively applying energy comprises the step of irradiating a portion of said transistor with a precisely directed laser beam pulse to cause charge to be selectively placed in said trapped-charge region.

3. The method of Claim 2 wherein said step of irradiating includes simultaneously irradiating the trapped-charge region and said control electrode means to produce photoelectrons which will flow through said insulating means.

4. The method of Claim 3 wherein said control electrode is biased with a negative voltage potential relative to said trapped-charge region whereby there is a net flow of photoelectrons toward said trapped-charge region to increase the potential between said control electrode means and said trapped-charge region.

5. The method of Claim 3 wherein said control electrode is biased with a positive voltage potential relative to said trapped-charge region whereby there is a net flow of photoelectrons toward said control electrode to reduce the potential between said control electrode means and said trapped-charge region.

6. The method of Claim 1 wherein said trapped-charge region is provided as a floating gate of an electrically conductive material.

7. The method of Claim 2 wherein said portion of said transistor is irradiated with an intense beam of ultraviolet radiation.

8. The method of Claim 1 wherein said step of applying energy selectively to said transistor comprises the step of applying thermal energy to a portion of said insulating means to temporarily increase the conductivity of said portion and provide a temporary path for the conduction of charge between said control electrode means and said trapped-charge region.

9. The method of Claim 1 further including the step of providing second insulation means between said trapped-charge region and said substrate, which insulating means has different dielectric properties than said insulating means between said trapped-charge region and said control electrode means.

10. The method of Claim 9 wherein said second insulating means is a dielectric layer of silicon dioxide, and said first insulating means is a dielectric layer of silicon nitride.

11. A discretionarily programmed transistor produced in accordance with the method of Claim 1.

12. A programmable transistor structure, comprising:

a substrate;

a source region associated with said substrate;

a drain region associated with said substrate;

a reprogrammable trapped-charge region associated with said substrate which has a charge stored therein for controlling conduction between said source region and said drain region;

said stored charge being provided by irradiating portions of the transistor structure with a beam of electromagnetic selected radiation which causes charge to be selectively placed in said trapped-charge region;

control electrode means having a control voltage applied thereto selected to control the amount of charge placed in the reprogrammable trapped-charge region and thereby determine the conduction characteristic of the transistor; and

insulating means between the trapped-charge region and the control electrode means.

13. The transistor structure of Claim 12 wherein the control electrode means is biasable with a negative voltage potential selected to cause photoelectrons to be directed toward the trapped-charge region and provide a net negative charge therein and wherein the control electrode means is biasable with a positive voltage potential selected to cause photoelectrons to be directed toward the control electrode means and provide a net positive charge in the trapped-charge region; and wherein said beam electromagnetic radiation is a laser beam which is incident upon both said trapped-charge region and said control electrode means to cause photoelectrons to be emitted.

14. The transistor structure of Claim 13 wherein the trapped-charge region is a floating gate.

15. The transistor structure of Claim 14 wherein the floating gate is polysilicon.

16. The transistor of Claim 14 wherein the control electrode means overlies the floating gate.

17. The transistor structure of Claim 12 wherein said electromagnetic radiation is ultraviolet radiation.

18. The transistor structure of Claim 12 wherein the substrate is silicon and the insulating means is silicon dioxide.

19. The transistor of Claim 12 wherein said electromagnetic radiation is provided by a pulsed laser beam which is directed to heat the insulating means to temporarily increase the conductivity thereof and provide a temporary conductive path for charge between the control electrode means and the trapped-charge region so that the trapped-charge region has a predetermined charge when the insulating means cools and removes the conductive path for charge.

20. The transistor structure of Claim 19 wherein the insulating means includes a first dielectric layer positioned between the substrate and the trapped--charge region and a second dielectric layer positioned between the control electrode means and the trapped--charge region, and the pulsed laser beam heats the second dielectric layer to temporarily increase its conductivity to provide a conductive path therethrough to the trapped-charge region.

21. The transistor structure of Claim 19 wherein said laser means emits optical radiation.

22. The transistor structure of Claim 20 wherein said first and second dielectric layers have different dielectric properties and the trapped-charge region is provided by the interface between the layers.

23. The transistor structure of Claim 22 wherein the first dielectric layer includes silicon dioxide and the second dielectric layer includes silicon nitride.

24. The transistor of Claim 12 including a substrate having formed thereon a plurality of source and drain regions having individual trapped-charge regions independently programmable by a beam of electromagnetic radiation.

25. The transistor of Claim 24 wherein the control electrode means provides a common control voltage for the plurality of trapped-charge regions.

30 LASER BEAM
10
26
2
2
24
20
18
12
14
22
16
30
34
24
e-
e-
32
20
10
20
16
26
14
30 LASER BEAM


FIG. 1

FIG. 2

FIG. 3

40
60 LASER BEAM
54
50
64
48
e⁻
e⁻
42
44
46
56
62


FIG. 4

40
50
46
58
60 LASER BEAM
44
56
60'


FIG. 5

90 LASER BEAM
70
86
84
80
78
74
82
72
76

FIG. 6

70
80
76
86
74
90 LASER BEAM

FIG. 7

100
120 LASER BEAM
105
108
116
110
107
104
112
106
102

FIG. 8

100
120 LASER BEAM
104
116
106
105
107

FIG. 9